# EUROPEAN PATENT SPECIFICATION

(11) **EP 2 753 867 B1**
(45) Date of publication and mention of the grant of the patent: **21.10.2015**
(21) Application number: 12753482.4
(22) Date of filing: 31.08.2012
(51) Int. Cl.: F21V 5/04, F21V 31/04, H05K 1/03, F21Y 101/02

(54) **AN LED LIGHTING APPARATUS, A METHOD FOR MANUFACTURING THE SAME AND AN LED ADVERTISEMENT MODULE HAVING THE LED LIGHTING APPARATUS**
LED-BELEUCHTUNGSVORRICHTUNG, VERFAHREN ZU IHRER HERSTELLUNG UND LED-WARNMODUL MIT DER LED-BELEUCHTUNGSVORRICHTUNG
DISPOSITIF D'ÉCLAIRAGE À DIODES ÉLECTROLUMINESCENTES, SON PROCÉDÉ DE FABRICATION ET MODULE PUBLICITAIRE À DIODES ÉLECTROLUMINESCENTES COMPRENANT LE DISPOSITIF D'ÉCLAIRAGE À DIODES ÉLECTROLUMINESCENTES

(30) Priority: 06.09.2011 CN 201110262089
(43) Date of publication of application: 16.07.2014
(73) Proprietor: OSRAM GmbH, 80807 München (DE)
(72) Inventor: FAN, Huajian, Shenzhen Guangdong 518053 (CN); FENG, Yaojun, Shenzhen Guangdong 518053 (CN); HE, Yuanyuan, Shenzhen Guangdong 518053 (CN); HE, Yubao, Shenzhen Guangdong 518053 (CN)
(86) International application number: PCT/EP2012/066991
(87) International publication number: WO 2013/034501

(56) References cited:
- US-A1- 2003 072 153
- US-A1- 2007 139 949
- US-A1- 2008 174 993

## Description

### Technical Field

The present invention relates to an LED lighting apparatus. In addition, the present invention further relates to a method for manufacturing the LED lighting apparatus and an LED advertisement module having the LED lighting apparatus.

### Background Art

The LED illumination has the advantages of a high luminescent efficiency, a small energy consumption and environmental protection. Moreover, the cost becomes lower and lower with the continuous development of the LED illuminating technology. Therefore, people would like to use the LED more and more as a light source to be applied to the illuminating apparatus of the existing types. Generally, an LED chip of the LED lighting apparatus is mounted on a printed circuit board on which an optical device enclosing the LED chip is provided, and then the LED lighting apparatus is encapsulated with an encapsulating glue by a coating and injecting process. During the encapsulation, a potting pressure may be higher than 100 atm, which results in different pressures on both sides of a region of the printed circuit board corresponding the optical device, because there may be only one atmospheric pressure on one side of the printed circuit board corresponding to the optical device, while the other side of the printed circuit board needs to bear more than 100 atmospheric pressure, then the printed circuit board might be deformed and finally the LED chip mounted thereon will be damaged.

In order to solve the above problem, a method of increasing the thickness of the printed circuit board is usually used in the prior art, while this method cannot solve the above technical problem completely, since a printed circuit board with a specific thickness can only bear a specific pressure, and the thickness should be further increased if the pressure exceeds the specific pressure, which will lead to the problem of continuously increased cost. The cost will be increased by over 40% if the thickness of the printed circuit board is increased from 1.2 mm to 2.0 mm. At the same time, the increased thickness of the printed circuit board also will further decrease the thermal dissipating performance of the whole LED lighting assembly.

An earlier patent application US 2003/072153 A1 discloses a lighting apparatus comprising a substrate and a heat dissipation board adhered to the substrate. The heat dissipation board could be also used as reinforcing board, but no buffer cavity is formed between the substrate and the heat dissipation board.

### Summary of the Invention

In order to solve the above problem, the present invention provides an LED lighting apparatus that is capable of completely avoiding damage to an LED chip due to the encapsulation process during the encapsulation, and meanwhile, has a better thermal dissipating performance. In addition, the present invention further provides a method for manufacturing the LED lighting apparatus and an LED advertisement module having the LED lighting apparatus of the above type.

The first object of the present invention is accomplished via an LED lighting apparatus through the following solution. The LED lighting apparatus comprises: a printed circuit board, an LED chip arranged on one side of the printed cir cuit board, and an optical device arranged on the printed circuit board and enclosing the LED chip, wherein the LED lighting apparatus is encapsulated with an encapsulating glue, and wherein the LED lighting apparatus further comprises a reinforcing board arranged on a region at least corresponding to a region defined by the optical device on the printed circuit board and on the other side of the printed circuit board. During practical fabrication of the LED lighting apparatus, the LED chip usually needs to be equipped with a specially designed optical device such as LED lens in order to enable the LED chip to have a good optical performance. During the encapsulation, the encapsulating glue should encapsulate the entire LED lighting apparatus, but since the LED lens envelops the LED chip, a cavity is thus formed in the LED lens. And during the encapsulation, the pressures in and outside of the cavity are inconsistent, then the printed circuit board may be caused deformed. In one solution of the present invention, a reinforcing board is arranged on a region corresponding to a region defined by the optical device on the printed circuit board and on the other side of the printed circuit board. The reinforcing board bears the pressure in encapsulation, so that the deformation of the printed circuit board is effectively prevented, and further the damage to the LED chip is avoided.

Preferably, the reinforcing board is fixed on the other side of the printed circuit board by a surface assembling process. Such common assembling process is simple and practicable, and has a low cost.

According to one preferred solution of the present invention, the reinforcing board is welded via a soldering pad on the other side of the printed circuit board, wherein a coverage region of the soldering pad at least corresponds to a region where the optical device contacts the printed circuit board. The soldering pad completely covers the region where the optical device contacts the printed circuit board, so that no force will be exerted on the region where the optical device contacts the printed circuit board, thus preventing the deformation of the printed circuit board in the region, and further avoiding the damage to the LED chip.

Further preferably, the soldering pad is configured to be disk-shaped, and a coverage region of the disk-shaped soldering pad corresponds to the region defined by the optical device on the printed circuit board. In this situation, since the reinforcing board is completely against the other side of the printed circuit board and has a sufficient strength, it will not be deformed when bearing an external force, so as to prevent the deformation of the printed circuit board, and further to avoid the damage to the LED chip.

Optionally, the soldering pad is configured to be ring-shaped. The ring-shaped soldering pad defines a closed buffer cavity between the reinforcing board and the printed circuit board. The reinforcing board might be deformed when bearing an external force, and bent to go into the buffer cavity, but the buffer cavity may effectively prevent the bent reinforcing board from further applying a force to the printed circuit board, so as to prevent the deformation of the printed circuit board and further to avoid the damage to the LED chip.

Further preferably, the optical device and one side of the printed circuit board define a cavity and the reinforcing board is provided on a region corresponding to the cavity on the other side of the printed circuit board. Accordingly, the reinforcing board can effectively prevent deformation of the printed circuit board while occupying an area, as small as possible, of the other side of the printed circuit board, further avoiding the damage to the LED chip.

Preferably, the reinforcing board is made from copper or aluminum. Of course, the reinforcing board also may be made from other materials having a sufficient strength. The thermal dissipating performance of the LED lighting apparatus also can be prominently improved by using materials such as copper and aluminum having a high thermal dissipating performance.

Preferably, the encapsulating glue is an epoxy resin encapsulating glue, a silicon rubber encapsulating glue, a polyurethane encapsulating glue, a UV encapsulating glue or a hot melting encapsulating glue. Of course, the encapsulating glue also may be an encapsulating glue made from other materials.

According to the present invention, the LED lighting apparatus is encapsulated with the encapsulating glue by a coating and injecting process.

Preferably, the optical device is configured as an LED lens that may be a lens specially designed for the LED chip.

The other object of the present invention is accomplished via an LED advertisement module through the following solution. The LED advertisement module has at least one LED lighting apparatus of the above type. The production yield of the LED advertisement module is higher in the fabrication with a better thermal dissipating performance.

The last object of the present invention is accomplished via a method for manufacturing the LED lighting apparatus of the above type. The method includes steps of a) providing printed circuit board arranged with an LED chip; b) arranging an optical device configured as an LED lens on the printed circuit board to define, with the printed circuit board, a cavity accommodating the LED chip; c) arranging a reinforcing board on a region at least corresponding to a region defined by the cavity on the printed circuit board and on the other side of the printed circuit board; and d) encapsulating the LED lighting apparatus with an encapsulating glue. During the encapsulation process of the LED lighting apparatus manufactured with the method according to the present invention, the deformation of the printed circuit board is effectively prevented, and the damage to the LED chip is further avoided, so that the production yield of the LED lighting apparatus is significantly improved.

### Brief Description of the Drawings

The accompanying drawings constitute a part of the present Description and are used to provide further understanding of the present invention. Such accompanying drawings illustrate the embodiments of the present invention and are used to describe the principles of the present invention together with the Description. In the accompanying drawings the same components are represented by the same reference numbers. As shown in the drawings:
Fig. 1 is a schematic diagram of a first embodiment of an LED lighting apparatus according to the present invention;
Fig. 2 is a sectional view of the first embodiment of the LED lighting apparatus according to the present invention;
Fig. 3 is a schematic diagram of a second embodiment of an LED lighting apparatus according to the present invention;
Fig. 4 is a sectional view of the second embodiment of the LED lighting apparatus according to the present invention; and
Fig. 5 is a schematic diagram of a reinforcing board deformed when bearing a force in the second embodiment.

### Detailed Description of the Embodiments

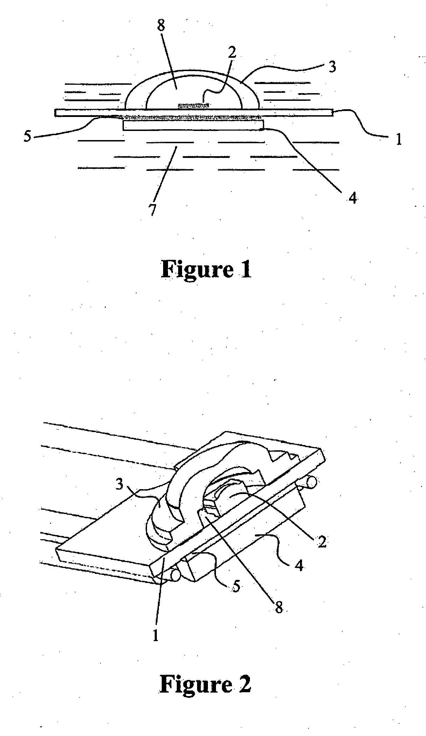

Fig. 1 is a schematic diagram of a first embodiment of an LED lighting apparatus according to the present invention. It can be seen from the figure that the LED lighting apparatus comprises a printed circuit board 1, an LED chip 2 arranged on one side of the printed circuit board 1, and an optical device 3 arranged on the printed circuit board 1 and enclosing the LED chip 2. The optical device 3 is configured as an LED lens in the present embodiment and following embodiments. In one solution of the present invention, the optical device 3 defines a cavity 8 on the printed circuit board 1, and the LED chip 2 is accommodated in the cavity 8. As can be seen from the figure, the other side of the printed circuit board 1 is arranged with a reinforcing board 4 made from materials such as cooper or aluminum having a high strength and a good thermal conductive performance. In the first embodiment, the reinforcing board 4 is fixed via a disk-shaped soldering pad 5 on the other side of the printed circuit board 1. In the present embodiment, the soldering pad 5 is disk-shaped, and regions occupied by the soldering pad 5 and the reinforcing board 4 at least correspond to a region defined by the optical device 3 on the printed circuit board 1; moreover, the reinforcing board 4 has a sufficient strength so that an encapsulating pressure will be completely exerted on the reinforcing board 4 when an encapsulating glue 7 is used for encapsulation; in addition, the reinforcing board 4 bears the pressure to prevent deformation of the printed circuit board 1, and further to avoid damage to the LED chip 2. In a preferred solution of the present invention, the reinforcing board 4 is merely provided on a region corresponding to the cavity 8 on the other side of the printed circuit board 1.

Fig. 2 is a sectional view of the first embodiment of the LED lighting apparatus according to the present invention. As can be seen from the figure, the disk-shaped soldering pad 5 completely covers, on the other side of the printed circuit board 1, a region corresponding to a region defined by the optical device 3 on the printed circuit board 1. Accordingly, the reinforcing board 4 is completely against the printed circuit board 5 via the disk-shaped soldering pad 5, prevents the deformation thereof with its own rigidity when bearing a force, and further avoids the deformation of the printed circuit board 1.

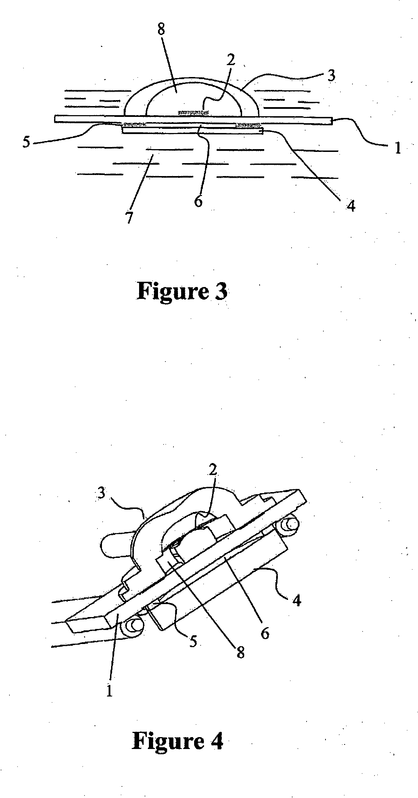

Fig. 3 is a schematic diagram of a second embodiment of an LED lighting apparatus according to the present invention, merely differing from the embodiment shown in Fig. 1 in that the other side of the printed circuit board 1 is arranged with a ring-shaped soldering pad 5 that defines a closed buffer cavity 6 between the reinforcing board 4 and the printed circuit board 1. The reinforcing board 4 will be bent, when deformed due to a force, to go into the buffer cavity 6, consequently, the pressure during the encapsulation will be counteracted to prevent the deformation of the printed circuit board 1 and further to avoid the damage to the LED chip 2.

Fig. 4 is a sectional view of the second embodiment of the LED lighting apparatus according to the present invention. The buffer cavity 6 formed between the reinforcing board 4 and the printed circuit board 1 and defined by the ring-shaped soldering pad 5 can be seen more directly from the sectional view.

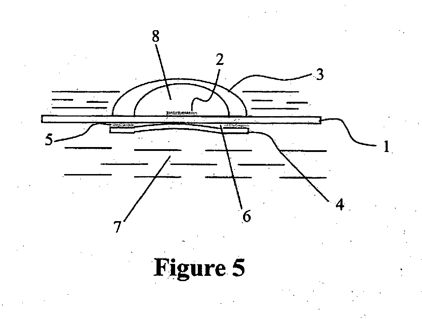

Fig. 5 is a schematic diagram of a reinforcing board deformed when bearing a force in the second embodiment. As can be seen from the figure, after a pressure of the encapsulating glue 7 is exerted on the reinforcing board 4, the reinforcing board 4 is deformed due to pressure and bent towards the buffer cavity 6; but after the encapsulation is completed, the printed circuit board 1 is not deformed, which effectively avoids the damage to the LED chip 2.

### List of reference signs

- 1: printed circuit board
- 2: LED chip
- 3: optical device (LED lens)
- 4: reinforcing board
- 5: soldering pad
- 6: buffer cavity
- 7: encapsulating glue
- 8: cavity

## Claims

1. An LED lighting apparatus comprising: a printed circuit board (1), an LED chip (2) arranged on one side of the printed circuit board (1), and an optical device (3) arranged on the printed circuit board (1) and enclosing the LED chip (2), wherein the LED lighting apparatus further comprises a reinforcing board (4) arranged on a region at least corresponding to a region defined by the optical device (3) on the printed circuit board (1) and on the other side of the printed circuit board (1), **characterized in that** the LED lighting apparatus is encapsulated with an encapsulating glue (7) and the reinforcing board (4) is welded via a soldering pad (5) on the other side of the printed circuit board (1), and wherein a coverage region of the soldering pad (5) at least corresponds to a region where the optical device (3) contacts the printed circuit board (1), and wherein the soldering pad (5) is configured to be ring-shaped, and the ring-shaped soldering pad (5) defines a closed buffer cavity (6) between the reinforcing board (4) and the printed circuit board (1).

2. The LED lighting apparatus according to Claim 1, where-in the reinforcing board (4) is fixed on the other side of the printed circuit board (1) by a surface assembling process.

3. The LED lighting apparatus according to Claim 1, wherein the optical device (3) and the printed circuit board (1) define a cavity (8) and the reinforcing board (4) is provided on a region corresponding to the cavity (8) on the other side of the printed circuit board (1).

4. The LED lighting apparatus according to any one of Claims 1-3, wherein the reinforcing board (4) is made from copper or aluminum.

5. The LED lighting apparatus according to any one of Claims 1-3, wherein the encapsulating glue (7) is an epoxy resin encapsulating glue, a silicon rubber encapsulating glue, a polyurethane encapsulating glue, a UV encapsulating glue or a hot melting encapsulating glue.

6. The LED lighting apparatus according to any one of Claims 1-3, wherein the LED lighting apparatus is encapsulated with the encapsulating glue (7) by a coating and injecting process.

7. The LED lighting apparatus according to any one of Claims 1-3, wherein the optical device (3) is configured as an LED lens.

8. An LED advertisement module, wherein the LED advertisement module has at least one LED lighting apparatus according to any one of Claims 1-7.

9. A method for manufacturing the LED lighting apparatus according to any one of Claims 1-7 including steps of
a) providing a printed circuit board (1) arranged with an LED chip (2);
b) arranging an optical device (3) configured as an LED lens on the printed circuit board (1) so as to define, with the printed circuit board (1), a cavity (8) accommodating the LED chip (2);
c) arranging a reinforcing board (4) on a region at least corresponding to a region defined by the cavity (8) on the printed circuit board (1) and on the other side of the printed circuit board (1); and
d) encapsulating the LED lighting apparatus with an encapsu lating glue (7).

## Patentansprüche

1. LED-Beleuchtungsvorrichtung, die umfasst: eine gedruckte Leiterplatte (1), einen LED-Chip (2), der an einer Seite der gedruckten Leiterplatte (1) angeordnet ist, und eine optische Einrichtung (3), die auf der gedruckten Leiterplatte (1) angeordnet ist und den LED-Chip (2) umschließt, wobei die LED-Beleuchtungsvorrichtung ferner eine Verstärkungsplatte (4) umfasst, die in einer Region, welche zumindest einer Region entspricht, die von der optischen Einrichtung (3) auf der gedruckten Leiterplatte (1) gebildet ist, auf der anderen Seite der gedruckten Leiterplatte (1) angeordnet ist,
**dadurch gekennzeichnet, dass**
die LED-Beleuchtungsvorrichtung mit einem kapselnden Kleber (7) gekapselt ist, die Verstärkungsplatte (4) über ein Lötpad (5) auf der anderen Seite der gedruckten Leiterplatte (1) angeschweißt ist und wobei eine Abdeckregion des Lötpads (5) zumindest einer Region entspricht, in der die optische Einrichtung (3) die gedruckte Leiterplatte (1) kontaktiert, und wobei das Lötpad (5) ringförmig ausgebildet ist und das ringförmige Lötpad (5) einen geschlossenen Pufferhohlraum (6) zwischen der Verstärkungsplatte (4) und der gedruckten Leiterplatte (1) bildet.

2. LED-Beleuchtungsvorrichtung nach Anspruch 1, wobei die Verstärkungsplatte (4) mittels eines Flächenzusammenfügeprozesses auf der anderen Seite der gedruckten Leiterplatte (1) befestigt wird.

3. LED-Beleuchtungsvorrichtung nach Anspruch 1, wobei die optische Einrichtung (3) und die gedruckte Leiterplatte (1) einen Hohlraum (8) bilden und die Verstärkungsplatte (4) auf der anderen Seite der gedruckten Leiterplatte (1) in einer Region vorgesehen ist, die dem Hohlraum (8) entspricht.

4. LED-Beleuchtungsvorrichtung nach einem der Ansprüche 1-3, wobei die Verstärkungsplatte (4) aus Kupfer oder Aluminium gefertigt ist.

5. LED-Beleuchtungsvorrichtung nach einem der Ansprüche 1-3, wobei der kapselnde Kleber (7) ein kapselnder Kleber aus Epoxidharz, ein kapselnder Kleber aus Silikonkautschuk, ein kapselnder Kleber aus Polyurethan, ein kapselnder UV-Kleber oder ein kapselnder Heißschmelzkleber ist.

6. LED-Beleuchtungsvorrichtung nach einem der Ansprüche 1-3, wobei die LED-Beleuchtungsvorrichtung mittels eines Beschichtungs- und Einspritzprozesses mit dem kapselnden Kleber (7) gekapselt wird.

7. LED-Beleuchtungsvorrichtung nach einem der Ansprüche 1-3, wobei die optische Einrichtung (3) als LED-Linse ausgebildet ist.

8. LED-Warnmodul, wobei das LED-Warnmodul mindestens eine LED-Beleuchtungsvorrichtung nach einem der Ansprüche 1-7 aufweist.

9. Verfahren zum Herstellen der LED-Beleuchtungsvorrichtung nach einem der Ansprüche 1-7, das folgende Schritte umfasst:
a) Bereitstellen einer gedruckten Leiterplatte (1), die mit einem LED-Chip (2) angeordnet ist;
b) Anordnen einer optischen Einrichtung (3), die als LED-Linse ausgebildet ist, auf der gedruckten Leiterplatte (1), um mit der gedruckten Leiterplatte (1) einen Hohlraum (8) zu bilden, der den LED-Chip (2) aufnimmt;
c) Anordnen einer Verstärkungsplatte (4) in einer Region, die zumindest einer Region entspricht, welche von dem Hohlraum (8) auf der gedruckten Leiterplatte (1) gebildet ist, auf der anderen Seite der Leiterplatte (1); und
d) Kapseln der LED-Beleuchtungsvorrichtung mit einem kapselnden Kleber (7).

## Revendications

1. Appareil d'éclairage à LED comprenant : une carte de circuit imprimé (1), une puce de LED (2) agencée sur un côté de la carte de circuit imprimé (1), et un dispositif optique (3) agencé sur la carte de circuit imprimé (1) et entourer la puce LED (2), dans lequel l'appareil d'éclairage à LED comprend en outre une plaque de renfort (4) agencée sur une région correspondant au moins à une région définie par le dispositif optique (3) sur la carte de circuit imprimé (1) et sur l'autre côté de la carte de circuit imprimé (1), **caractérisé en ce que** l'appareil d'éclairage à LED est encapsulé avec une colle d'encapsulation (7), et la plaque de renfort (4) est soudée par l'intermédiaire d'un plat de soudure (5) sur l'autre côté de la carte de circuit imprimé (1), et dans lequel une région de couverture du plat de soudure (5) correspond au moins à une région où le dispositif optique (3) est en contact avec la carte de circuit imprimé (1), et dans lequel le plat de soudure (5) est configuré pour être de forme annulaire, et le plat de soudure de forme annulaire (5) définit une cavité tampon fermée (6) entre la plaque de renfort (4) et la carte de circuit imprimé (1).

2. Appareil d'éclairage à LED selon la revendication 1, dans lequel la plaque de renfort (4) est fixée sur l'autre côté de la carte de circuit imprimé (1) par un procédé de montage de surface.

3. Appareil d'éclairage à LED selon la revendication 1, dans lequel le dispositif optique (3) et la carte de circuit imprimé (1) définissent une cavité (8) et la plaque de renfort (4) est disposée sur une région correspondant à la cavité (8) sur l'autre côté de la carte de circuit imprimé (1).

4. Appareil d'éclairage à LED selon l'une quelconque des revendications 1 à 3, dans lequel la plaque de renfort (4) est constituée de cuivre ou d'aluminium.

5. Appareil d'éclairage à LED selon l'une quelconque des revendications 1 à 3, dans lequel la colle d'encapsulation (7) est une colle d'encapsulation à base de résine époxy, une colle d'encapsulation à base de caoutchouc de silicium, une colle d'encapsulation à base de polyuréthane, une colle d'encapsulation à UV ou une colle d'encapsulation thermofusible.

6. Appareil d'éclairage à LED selon l'une quelconque des revendications 1 à 3, dans lequel l'appareil d'éclairage à LED est encapsulé avec la colle d'encapsulation (7) par un procédé de revêtement et d'injection.

7. Appareil d'éclairage à LED selon l'une quelconque des revendications 1 à 3, dans lequel le dispositif optique (3) est configuré sous forme de lentille LED.

8. Module publicitaire à LED, dans lequel le module publicitaire à LED comporte au moins un appareil d'éclairage à LED selon l'une quelconque des revendications 1 à 7.

9. Procédé de fabrication du appareil d'éclairage à LED selon l'une quelconque des revendications 1 à 7 comprenant les étapes consistant à :
a) fournir une carte de circuit imprimé (1) agencée avec une puce de LED (2) ;
b) agencer un dispositif optique (3) configuré sous forme de lentille LED sur la carte de circuit imprimé (1) de manière à définir, avec la carte de circuit imprimé (1), une cavité (8) recevant la puce de LED (2) ;
c) agencer une plaque de renfort (4) sur une région correspondant au moins à une région définie par la cavité (8) sur la carte de circuit imprimé (1) et sur l'autre côté de la carte de circuit imprimé (1) ; et
d) encapsuler l'appareil d'éclairage à LED avec une colle d'encapsulation (7).
